# EUROPEAN PATENT APPLICATION

(11) **EP 4 826 908 A1**
(43) Date of publication of application: **21.10.2026**
(21) Application number: 25170245.2
(22) Date of filing: 14.04.2025
(51) Int. Cl.: H01Q 1/22, H01P 5/107

(54) **RADIO-FREQUENCY DEVICE HAVING A RADIO-FREQUENCY SEMICONDUCTOR DIE EMBEDDED WITHIN A SUBSTRATE**

(71) Applicant: Infineon Technologies AG, 85579 Neubiberg (DE)
(72) Inventor: HARTNER, Walter, 93077 Bad Abbach (DE); THEUSS, Horst, 93173 Wenzenbach (DE); GEIßLER, Christian, 93356 Teugn (DE)
(74) Representative: Infineon Patent Department

(57) **Abstract**

The present disclosure relates to a radio-frequency (RF) device comprising a substrate comprising a first layer, a second layer and a metal structure. The RF device further comprises an RF semiconductor die embedded within the substrate and surrounded by a material of the first layer of the substrate. The RF semiconductor die is coupled with the metal structure. The metal structure extends in a first direction parallel and in a second direction vertical to a first surface of the substrate. The RF device further comprises a waveguide antenna formed from the metal structure in the second layer of the substrate to transfer RF signals from the RF semiconductor die to outside of the RF device or from outside of the RF device to the RF semiconductor die.

## Description

### TECHNICAL FIELD

The present disclosure relates to a radio-frequency device having a radio-frequency semiconductor die embedded within a substrate. The present disclosure further relates to a method of producing such radio-frequency device.

### BACKGROUND

Radio-frequency (RF) devices may typically be used to receive, transmit and process RF signals. The RF devices may have a packaged RF semiconductor die and a waveguide antenna mounted on a printed circuit board. The packaged RF semiconductor die and the waveguide antenna are mounted over a surface of the printed circuit board. In particular, the packaged RF semiconductor die is mounted on the printed circuit board via an array of solder balls. The printed circuit board has a launcher or an antenna configured to transfer and receive RF signals between the packaged RF semiconductor die and the waveguide antenna. The launcher or the antenna is coupled with the solder ball via a microstrip. The solder ball may be damaged due to thermal disturbances or stress between the printed circuit board and the packaged RF semiconductor die and thus affecting the integrity of RF signals transferred to the launcher or antenna.

Furthermore, the packaged RF semiconductor die has an RF semiconductor die encapsulated by a molded body. Therefore, a footprint of the packaged RF semiconductor die is larger than a footprint of the RF semiconductor die itself. In order to increase functionality of the RF device, a number of transmission/receive channels of the RF device has to be increased which is achieved by mounting additional packaged RF semiconductor dies and additional waveguide antennas over the surface of the printed circuit board. As, the surface of the printed circuit board has a limited area, additional packaged RF semiconductor dies and the waveguide antennas may introduce challenges such an increase in a size or footprint of the RF device, increase in cost due to additional packaged RF semiconductor die and the waveguide antenna, electromagnetic interference among the packaged RF semiconductor dies, and thermal management, which can significantly degrade the overall performance of the RF device.

A desire exists to provide a radio-frequency device that enables efficient transmission and reception of RF signals while minimizing signal loss, electromagnetic interference, thermal issues, and without significant increase in footprint of the radio-frequency device.

### SUMMARY

The present disclosure relates to a radio-frequency (RF) device comprising a substrate comprising a first layer, a second layer and a metal structure. The RF device further comprises an RF semiconductor die embedded within the substrate and surrounded by a material of the first layer of the substrate. The RF semiconductor die is coupled with the metal structure. The metal structure extends in a first direction parallel and in a second direction vertical to a first surface of the substrate. The RF device further comprises a waveguide antenna formed from the metal structure in the second layer of the substrate to transfer RF signals from the RF semiconductor die to outside of the RF device or from outside of the RF device to the RF semiconductor die.

The present disclosure further relates to a method of forming a radio-frequency (RF) device comprising an RF semiconductor die embedded within a substrate. The method comprises: providing a substrate layer, attaching a first surface of the RF semiconductor die to a surface of the substrate layer, depositing a material over the surface of the substrate layer to form a first layer of the substrate such that the RF semiconductor die is surrounded by the material, forming a second layer of the substrate over the first layer of the substrate, wherein forming the second layer comprises forming a metal structure, and wherein a first section of the metal structure forms a waveguide antenna.

The present disclosure relates to a radio-frequency (RF) device comprising a substrate comprising a first layer and a metal structure. The RF device further comprises a bare RF semiconductor die embedded within the substrate. The bare RF semiconductor die is surrounded by and in contact with a material of the first layer of the substrate. The metal structure extends in a first direction parallel to a first surface of the substrate. The RF device further comprises a waveguide antenna mounted over the first surface of the substrate to transfer RF signals from the bare RF semiconductor die to outside of the RF device via the metal structure or from outside of the RF device to the bare RF semiconductor die via the metal structure.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Figure 1 illustrates an example of a radio-frequency (RF) device having an RF semiconductor die within a substrate and a waveguide antenna formed within the substrate.
Figure 2 illustrates an example of a further RF device having a launcher within a substrate.
Figure 3 illustrates an example of a further RF device having an air-filled waveguide antenna formed within a substrate.
Figure 4 illustrates another example of the RF device of Figure 3, wherein an opening of the air-filled waveguide antenna is covered by a layer of the substrate.
Figure 5 illustrates an example of a further RF device, wherein a metal structure of a substrate has a via separating a first portion and a second portion of a waveguide antenna.
Figure 6 illustrates an example a further RF device having a molded RF semiconductor die embedded within a substrate.
Figure 7 illustrates an example of a further RF device having a semiconductor die coupled with a metal structure of substrate of the RF device.
Figure 8 illustrates an example of a further RF device, wherein a metal structure of a substrate comprises a heat sink.
Figure 9 illustrates an example of a further RF device having more than one RF semiconductor dies coupled by a transfer waveguide of a waveguide antenna.
Figure 10 illustrates an example of an RF device having a plurality of electrical contact pads.
Figures 11A-11D illustrate various steps of a method of forming an RF device with an RF semiconductor die embedded within a substrate and a waveguide antenna formed within the substrate.
Figures 12A-12C illustrate a further step of the method of Figure 11, wherein a launcher is formed within the substrate and coupled with the RF semiconductor die.
Figures 13A-13B illustrate a further step of the method of Figure 11, wherein a separation via is formed in a second layer of a substrate to separate two different portions of a waveguide antenna.
Figure 14 illustrates an alternative step of one of the steps of the method of Figure 11, wherein a molded RF semiconductor die is attached on a substrate.
Figure 15 illustrates an example of a radio-frequency (RF) device having a bare RF semiconductor die embedded within a substrate and a waveguide antenna mounted on the substrate.
Figure 16 illustrates an example of a further RF device with a bare RF semiconductor die having a launcher.
Figure 17 illustrates an example of a further RF device having more than one bare RF semiconductor dies coupled by a transfer waveguide of a waveguide antenna.

### DETAILED DESCRIPTION

Embodiments described herein provide a new concept of radio frequency (RF) devices. Today, the industry is seeking for solutions to increase functionalities of the RF devices without significantly increasing the footprint and cost of RF devices. The embodiments described herein allows an improved design of the RF device. The RF device has a substrate comprising a first layer, a second layer and a metal structure. An RF semiconductor die is embedded within the substrate and surrounded by a material of the first layer of the substrate. The RF semiconductor die is coupled with the metal structure and the metal structure extends in a first direction parallel and in a second direction vertical to a first surface of the substrate. A waveguide antenna is formed from the metal structure in the second layer of the substrate to transfer RF signals from the RF semiconductor die to outside of the RF device or from outside of the RF device to the RF semiconductor die. By embedding the RF semiconductor die within the substrate and forming the waveguide antenna within the substrate, an overall footprint of the RF device can be reduced as compared to the traditional RF devices. In addition, the signal path from the RF semiconductor die to the waveguide antenna can be shortened thereby reducing transmission losses. Also, the coupling into the waveguide antenna can be made more reliable and more efficient as the structures for coupling can be formed in the same way as the waveguide antenna without any additional soldering or mounting which makes the launching into the waveguide antenna more homogenous and reliable. Furthermore, for a given dimension of the substrate, the RF device can have a larger number of transmission/receive channels as compared to the traditional RF devices. Overall, the production costs can also be reduced as the packaging of the RF semiconductor die, the forming and connecting to a substrate (such as a printed circuit board) and the manufacturing of the waveguide antenna are integrated into one manufacturing process.

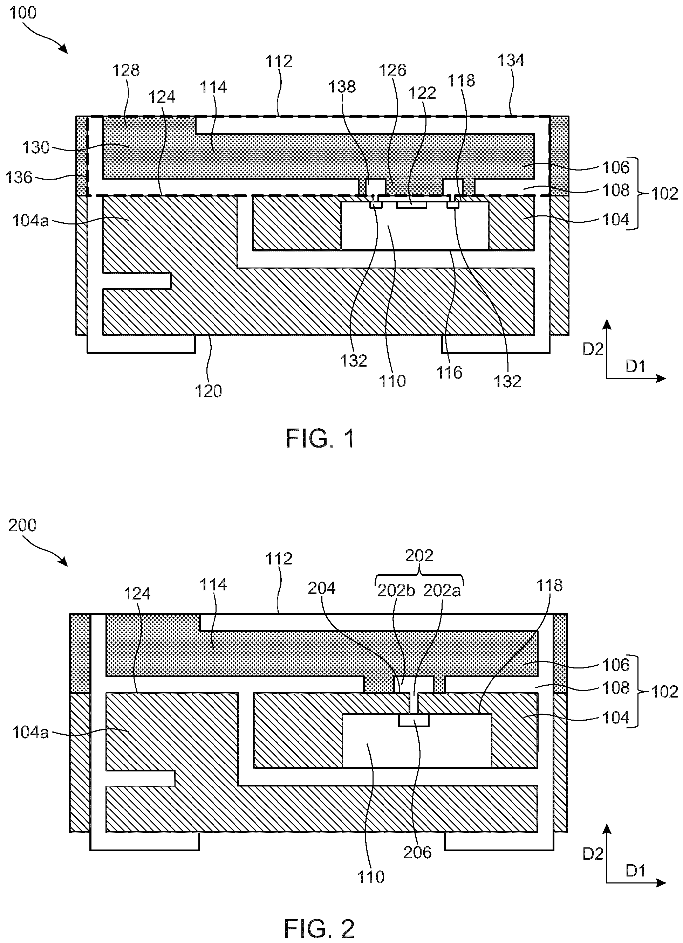

Figure 1 shows an example of a radio-frequency (RF) device 100. The RF device 100 has an RF semiconductor die 110 and a substrate 102. The substrate 102 has a first layer 104, a second layer 106 and a metal structure 108. In examples described herein, the substrate 102 may be a printed circuit board (PCB) and the RF semiconductor die 110 is embedded into the printed circuit board. The first layer 104 and the second layer 106 may be stacked vertically such that the second layer 106 is arranged above the first layer 104. The second layer 106 may be an outermost layer of the substrate 102. An outermost surface of the second layer 106 forms a first surface 112 of the substrate 102 which may be a first main surface. The first layer 104 may comprise a material 104a used for forming printed circuit boards (PCBs) e.g. but not limited to, FR4, epoxy, a polymer material, a prepreg material, or an Ajinomoto Build-up Film (ABF) material etc. The metal structure 108 may extend in a first direction D1 and in a second direction D2. The first direction D1 is parallel to the first surface 112 of the substrate 102 and the second direction D2 is vertical to the first surface 112 of the substrate 102. The metal structure 108 may comprise e.g. but not limited to aluminum, copper, silver, gold or an alloy thereof. Further, the metal structure 108 may include vias for forming vertical structures and/or plates for forming the horizontal structures. In examples described herein, the plates are formed from metallic layers of a printed circuit board and the vias are vias in the printed circuit board extending between the metallic layers. The metal structure 108 may extend in the first layer 104 and the second layer 106 and may also extend between the first layer 104 and the second layer 106. The metal structure 108 may extend on the first surface 112 and an opposing second surface 120 of the substrate 102.

In one example, the first layer 104 may be surrounded by another material e.g. but not limited to, FR4, epoxy, a polymer material, a prepreg material, or an Ajinomoto Build-up Film (ABF) material etc. in particular in the first direction D1.

As described herein, the RF device 100 includes the RF semiconductor die 110. The RF semiconductor die 110 may have, inter alia, RF front-end circuitry such as RF oscillators, amplifiers, and mixers, and base band (and/or intermediate frequency (IF) band) circuitry such as amplifiers and analog filters. Additionally, an analog-to-digital converter may be included in the RF semiconductor die 110 to digitize the base-band or IF-band signal. The RF semiconductor die 110 may operate at frequencies selected from a frequency range of 1 GHz to 500 GHz. In some examples, the RF semiconductor die 110 may operate in a frequency range, including but not limited to, microwave frequencies 1 GHz to 30 GHz, millimeter-wave frequencies 30 GHz to 300 GHz and sub-millimeter-wave frequencies 300 GHz to 500GHz. The front-end circuitry is formed on a frontside 118 of the RF semiconductor die 110. In some examples, the frontside 118 of the RF semiconductor die 110 faces the first surface 112 of the substrate 102. The RF semiconductor die 110 may have one or more channels configured to transmit or receive RF signals. The RF semiconductor die 110 may be a radar monolithic microwave integrated circuit (MMIC).

The RF semiconductor die 110 comprises a chip-integrated antenna or chip-integrated launcher 122 formed directly on the RF semiconductor die 110 in particular on the frontside 118 of the RF semiconductor die 110. In some examples, the chip-integrated antenna or chip-integrated launcher 122 may include a patch antenna or a launcher structure formed in a metal layer of the RF semiconductor die 110. The chip-integrated antenna or chip-integrated launcher 122 may be coupled to an RF channel via a waveguide or a microstrip. The chip-integrated antenna or chip-integrated launcher 122 of the RF semiconductor die 110 may transmit RF signals from the RF semiconductor die 110 or receive RF signals from outside of the RF semiconductor die 110. The chip-integrated antenna or chip-integrated launcher 122 may can be formed during manufacturing of the RF semiconductor die 110 and further can be precisely formed on the RF semiconductor die 110 at a desired location. The chip-integrated antenna or the chip-integrated launcher 122 can transfer RF signals wirelessly, thus enhancing the RF signal integrity and reduce losses for the RF signals. The chip-integrated antenna or the chip-integrated launcher 122 may be suitable for RF semiconductor die 110 operating in the sub-millimeter wave frequencies.

As described herein, the RF device 100 includes the RF semiconductor die 110. A backside 116 of the RF semiconductor die 110 may be arranged over a surface of an inner portion of the metal structure 108 in the first layer 104, wherein the backside 116 is opposite to the frontside 118 of the RF semiconductor die 110. The material 104a of the first layer 104 surrounds the RF semiconductor die 110. A thickness of the material 104a of the first layer 104 above the frontside 118 of the RF semiconductor die 110 measured in the second direction D2 may be less than 50 µm. Thus, the chip-integrated antenna or chip-integrated launcher 122 can transmit or couple the RF signals without significant signal loss due to the material 104a of the first layer 104.

The waveguide antenna 114 is implemented in the second layer 106. The second layer 106 may have a thickness in a range of 10 µm to 1000 µm, in particular 50 µm to 500 µm in particular 100 µm to 300 µm measured in the second direction D2. The waveguide antenna 114 is formed from the metal structure 108 in the second layer 106. The waveguide antenna 114 is configured to transfer the RF signals from the RF semiconductor die 110 to outside of the RF device 100 and vice-versa. In particular, the waveguide antenna 114 has a bottom wall 124 and an opposing top wall 134 connected by a side wall 136 of the waveguide antenna 114, as shown by a dotted rectangle in Figure 1. In one example, the bottom wall 124 of the waveguide antenna 114 may be at an interface of the first layer 104 and the second layer 106 whereas the top wall 134 of the waveguide antenna 114 may be at the first surface 112 of the substrate 102. The waveguide antenna 114 further has an inner opening 126 and an outer opening 128. The inner opening 126 faces the frontside 118 of the RF semiconductor die 110 in particular, the chip-integrated antenna or the chip-integrated launcher 122 such that RF signals can be coupled between the RF semiconductor die 110 and the waveguide antenna 114. The outer opening 128 extends to the first surface 112 of the substrate 102 and couples the RF signals between the waveguide antenna 114 and the outside of the RF device 100. In some examples, the outer opening 128 forms the radiating or receiving element for transmitting or receiving signals from the outside. In some examples, the outer opening 128 may have the form of a slit. The waveguide antenna 114 may be configured for transmission of signals in at least one of a TEM or TM or TE mode to or from the outer opening 128 of the waveguide antenna to the chip-integrated antenna or chip-integrated launcher 122.

In one example, the waveguide antenna 114 may be a dielectric filled hollow waveguide antenna. The second layer 106 may comprise a dielectric material 130 that may fill an inner volume of the waveguide antenna 114. The dielectric material 130 may comprise a low loss material e.g., but not limited to glass, epoxy, resin, polytetrafluoroethylene etc. Thus, RF signals are navigating within the waveguide antenna 114 are transmitted without significant losses. The use of dielectric material 130 may allow better adjustment of the waveguide antenna dimensions to the operating frequencies of the RF device 100. The dielectric material 130 is provided using well-known techniques e.g. but not limited to laminating process, deposition, molding or other techniques which makes the embedding process i.e., forming the stack of layers 104, 106 simple and cost -effective.

Optionally, the RF semiconductor die 110 may have an electrical contact pad 132 on the frontside 118 of the RF semiconductor die 110. The RF semiconductor die 110 is electrically coupled with the metal structure 108 through the electrical contact pad 132. The electrical contact pad 132 is configured to provide electrical connections to the RF semiconductor die 110 for transferring power and/or other signals such as measurement signal to or from other components integrated or mounted on the substrate 102. An electrical contact structure 138 may be electrically coupled with the electrical contact pad 132. The electrical contact structure 138 is formed from the metal structure 108. In one example, a part of the electrical contact structure 138 and the inner wall 124 of the waveguide antenna 114 may be made by selectively etching same section of the metal structure 108. Thus, the part of the electrical contact structure 138 and the inner wall 124 of the waveguide antenna 114 may be aligned in a common plane parallel the first direction D1.

The new concept provides the RF device having the substrate 102 with the first layer 104 and the second 106 layer. The RF semiconductor die 110 and the waveguide antenna 114 are integrated within the substrate 102. The use of the substrate 102 with multiple layers allow for integration of multiple components i.e., embedding the RF semiconductor die 110 in the first layer 104 and forming the waveguide antenna 114 from the metal structure 108 in the second layer 106. In other words, the substrate 102 can be used for routing electrical signals and RF signals in the RF device 100. The new concept allows to utilize an inner volume of the substrate 102 for integration of the RF semiconductor die 110 and the waveguide antenna 114. The integration of the RF semiconductor die 110 includes in examples a complete embedding of the RF semiconductor die 110 such that a material of the substrate 102 is surrounding the RF semiconductor die 110 on all sides of the semiconductor die 110. In some examples the material of the substrate 102 is in contact with the RF semiconductor die 110 on all sides of the semiconductor die 110. Accordingly, more space on the surface 112, 120 of the substrate 102 is available, allowing a mounting of other components like capacitors, inductors, or resistors etc. For a given volume of the substrate 102, the RF device 100 may have more RF semiconductor dies 110 and hence a larger number of transmission/receive channels as compared to the traditional RF devices. By forming the waveguide antenna 114 within the substrate 102, an RF signal path from the RF semiconductor die 110 to the radiating/receiving element is shortened. Furthermore, the RF signals are directly transferred to the waveguide antenna 114 in a wireless manner without the solder ball grid arrays and the microstrip, thus making the launching of RF signals into the waveguide antenna more homogenous and reliable. Thus, the risk of signal loss and degradation due to damage of the solder ball grid arrays and the microstrip can be completely avoided. Furthermore, the use of the waveguide antenna 114 formed from the metal structure 108 of the substrate 102 avoids the need for an external waveguide antenna, making the RF device more compact and cost-effective.

Figure 2 shows a further example of an RF device 200. The RF device 200 may include some or all features of the RF device 100 of Figure 1 and will be described in regards of differences only. For simplicity, the electrical contact pad is not shown in the RF device 200. The RF signals can be transferred between the RF semiconductor die 110 and the waveguide antenna 114 via a launcher 202 formed by the metal structure 108 instead of the chip-integrated antenna or the chip-integrated launcher in the RF semiconductor die 110. The RF semiconductor die 110 has an RF contact pad 206 on the frontside 118 of the RF semiconductor die 110 coupled with the channel of the RF semiconductor die 110.

The launcher 202 is within the substrate 102. A section 204 of the metal structure 108 forms the launcher 202 as shown in Figure 2. The launcher 202 is mounted over an RF contact pad 206 and thus coupled with the channel of the RF semiconductor die 110. The launcher 202 comprises a via 202a and a launch pad 202b. The via 202a may be partially in the first layer 104 whereas the launch pad 202b is in the second layer 106. The launch pad 202b and the inner wall 124 of the waveguide antenna 114 may be aligned to a common plane parallel to the first direction D1. In particular, the inner wall 134 of the waveguide antenna 114 and the launch pad 202b may be formed by selectively etching same section of the metal structure 108. The launcher 202 can directly couple RF signals into the waveguide antenna 114 formed in the second layer 106 and vice-versa. The launcher 202 may be used in applications using RF signals of millimeter wave frequencies or lower where the RF signals have a wavelength which is larger than a dimension of the RF semiconductor die 110, measured between opposing sides of the RF semiconductor die 110 vertical to the first surface 112 of the substrate 102. The use of the launcher 202 is however not limited to the above applications. The launcher 202 may improve coupling into the waveguide antenna 114 and thereby reduce the electromagnetic interference on the RF semiconductor die 110.

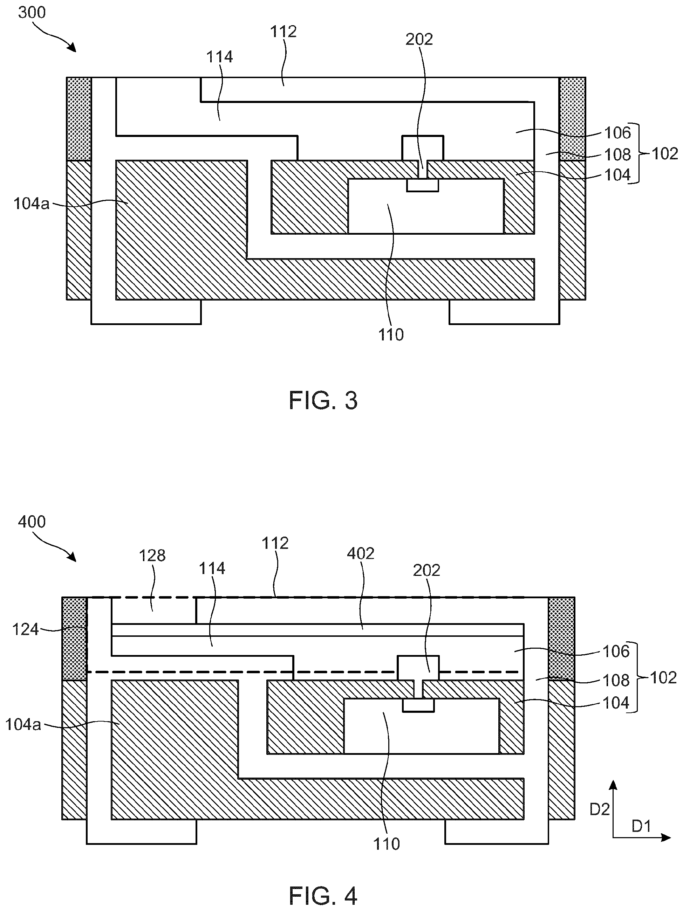

In a further example of an RF device 300, the waveguide antenna 114 may be an air-filled waveguide antenna as shown in Figure 3. With the air-filled waveguide antenna 114, losses occurring in waveguide antenna 114 due to the dielectric material 130 may be avoided.

Figure 4 shows a further example of an RF device 400 having the air-filled waveguide antenna 114. The RF device 400 may include some or all features of the RF device 100, 200, 300 of Figures 1 to 3 and will be described in regard to differences only. The substrate 102 has a third layer 402 extending in the first direction D1. The third layer 402 may be arranged within the second layer 106 such that the third layer 402 is within the inner volume of the waveguide antenna 114. Alternatively, the third layer 402 is arranged over the first surface 112 of the substrate 102. The third layer 402 may be configured to cover the outer opening 128 of the waveguide antenna 114. The third layer 402 may have a material comprising glass, epoxy, resin, polytetrafluoroethylene etc. The material of the third layer 402 is transparent to the RF signals. The third layer 402 acts as a barrier against external factors like moisture, dust or other contaminants from entering the waveguide antenna 114 and thus, protecting the RF semiconductor die 110 from external factors.

In one example, the third layer 402 within the outer opening 128 may be selectively etched to expose the outer opening 128 of the waveguide antenna 114.

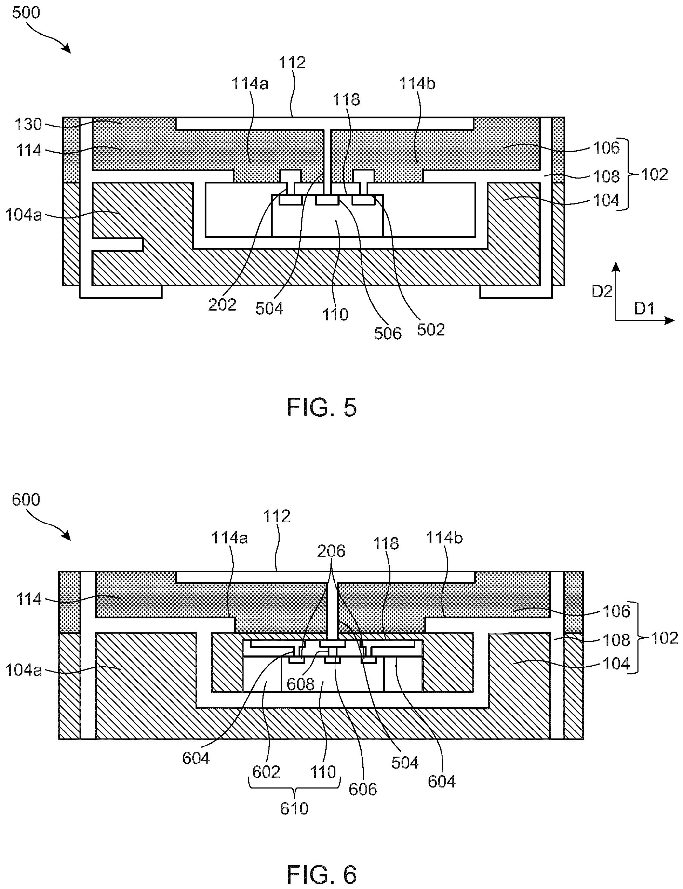

Figure 5 shows a further example of an RF device 500 having more than one RF channel and more than one launcher. The RF device 500 may include some or all features of the RF device 400 of Figure 4 and will be described in regard to differences only. The waveguide antenna 114 is shown in Figure 5 to be filled with the dielectric material 130, however it is to be understood that the waveguide antenna 114 can be in other examples include the air-filled waveguide antenna 114c.

The RF semiconductor die 110 may have multiple RF channels operating at a same frequency band or in multiple frequency bands. Thus, the RF device 500 may have multiple launchers 202, 502 such that each launcher of the plurality of launchers 202, 502 is coupled with a respective RF channel of a plurality of RF channels of the RF semiconductor die 110. The launcher 202 and the channel may be referred as a first launcher 202 and a first channel respectively. The RF device 500 may have a second launcher 502 coupled with a second channel of the RF semiconductor die 110. The first launcher 202 is coupled with a first portion 114a of the waveguide antenna 114 and the second launcher 502 is coupled with a second portion 114b of the waveguide antenna 114. In other words, the first launcher 202 couples RF signals associated with the first channel of the RF semiconductor die 110 into the first portion 114a of the waveguide antenna 114, whereas the second launcher 502 couples RF signals associated with the second channel of the RF semiconductor die 110 into the second portion 114b of the waveguide antenna 114. The first portion 114a and the second portion 114b of the waveguide antenna 114 are separated by a separation via 504. In some examples, another section of the metal structure 108 forms the separation via 504. The separation via 504 extends in the second direction D2. The separation via 504 may further extend into the first layer 104 and may be coupled with the frontside 118 of the RF semiconductor die 110. In particular, the separation via 504 is mechanically coupled with a ground pad 506 of the RF semiconductor die 110. Furthermore, the separation via 504 is between the first launcher 202 and the second launcher 502. The separation via 504 may reflect RF signals and thereby avoid interference between the RF signals in the first portion 114a and the second portion 114b of the waveguide antenna 114. Therefore, the interference between the RF signals transmitted by the respective launchers 202, 504 within the waveguide antenna 114 can be significantly reduced and the RF channels can be separated.

In one example, a contact structure like the electrical contact structure made from another section of the metal structure 108 may be coupled with the ground pad 506 and the separation via 504 is mechanically coupled with the contact structure.

Figure 5 shows an example of two launchers 202, 502, and two portions 114a, 114b of the waveguide antenna 114 separated by the separation via 504. It is understood that the RF device 500 may more than two launchers. Each launcher is coupled with the respective transmission line of RF semiconductor die 110 and the respective portion of the waveguide antenna 114. The different portions of the waveguide antenna 114 are separated by the respective separation via.

In one example, the RF device 500 may have two chip-integrated antennas or chip-integrated launchers integrated in the RF semiconductor die 110 as described in Figure 1, instead of the launchers 202, 502 formed from the metal structure. Each chip-integrated antenna or the chip-integrated launcher may be coupled with the respective channel of the RF semiconductor die 110 and with the respective portion 114a, 114b of the waveguide antenna 114 in order to transfer the RF signals between them. The separation via 504 may be directly coupled with the ground contact pad 506 and thus, avoids the interference of the RF signals transmitted into different portions of the waveguide antenna 114 by the chip-integrated antenna or chip-integrated launcher.

Figure 6 shows a further example of an RF device 600 having a molded RF semiconductor die 610. The RF device 600 may include some or all features of the RF device 500 of Figure 5 and will be described in regards of differences only. In the RF device 600, the RF semiconductor die 110 is surrounded by a molded body 602 before embedding the RF semiconductor die 110 within the substrate 110. The molded body 602 may protect the RF semiconductor die 110 from mechanical damage and contamination from the external factors like moisture, dust or other contaminants during embedding. The RF semiconductor die 110 with the molded body 602 forms the molded semiconductor die 610. The molded body 602 may comprise e.g. but not limited to epoxy, resin etc. The material 104a of the first layer 104 surrounds the molded body 602.

The molded RF semiconductor die 610 comprises a launcher 604 integrated within the molded body 602. The launcher 604 is coupled with the RF contact pad 206 of the RF semiconductor die 110 and coupled with the respective channel of the RF semiconductor die 110 via a redistribution layer (not shown in the Figure 6). The launcher 604 is in a fan-out area of the molded RF semiconductor die 110. The molded RF semiconductor die 610a with the launcher 604 in the fan-out area allows to increase a contact area of the launcher 604 as a width of the launcher 604 is not restricted to a width of the RF semiconductor die 110. This further simplifies the embedding of the RF semiconductor die 110 within the substrate 102.

In one example, the molded RF semiconductor die 610 may have at least two launchers 604 and a ground contact pad 606 between the launchers 604. Each launcher 604 is coupled with a respective portion 114a, 114b of the waveguide antenna 114. The ground contact pad 606 may be coupled with a contact structure 608. The contact structure 608 may be in the redistribution layer and exposed from the molded body 602. The separation via 502 may be mechanically coupled with the contact structure 608 of the molded RF semiconductor die 610 and thus separating the first portion 114a and the second portion 114b of the waveguide antenna and eventually the launchers 604 are isolated from each other.

In one example, the separation via 504 may be mechanically coupled with the molded body 602 instead the ground contact pad 606.

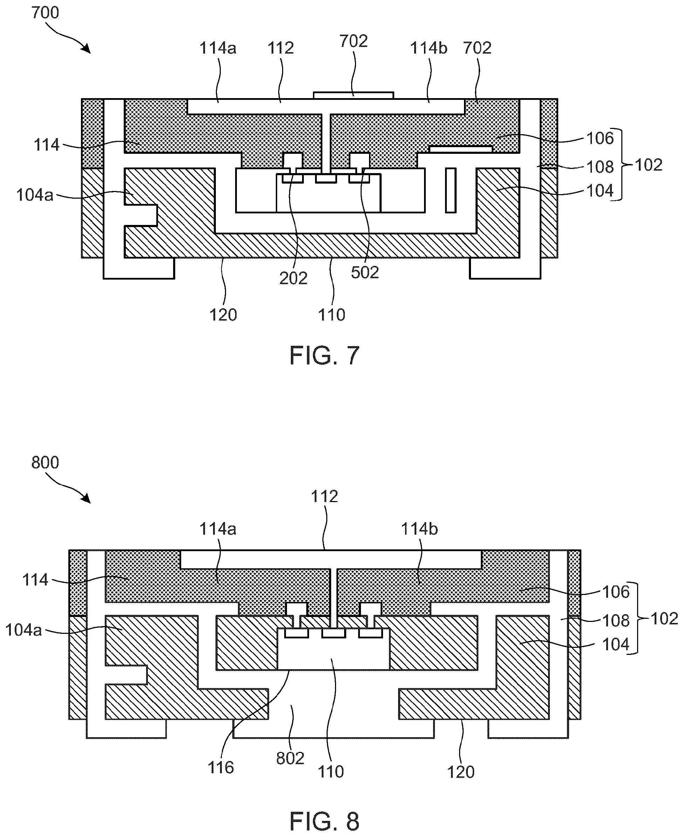

Figure 7 shows a further example of an RF device 700 having, in addition to the RF semiconductor die 110, a semiconductor die 702. The RF device 700 may include some or all features of the RF device 600 of Figure 6 and will be described in regards of differences only. The RF device 700 comprises the semiconductor die 702 electrically and mechanically coupled with the metal structure 108. The metal structure 108 electrically couples the RF semiconductor die 110 and the semiconductor die 702. The semiconductor die 702 may be embedded within the substrate 102. For example, the semiconductor die 702 can be arranged on the metal structure 108 within the layer 104, 106 of the substrate 102. Alternatively, the semiconductor die 702 may be arranged on the substrate 102. For example, the semiconductor die may be arranged outside of the substrate 102 i.e., on the part of the metal structure 108 extending on the surface 112, 120 of the substrate 102 as shown in Figure 7. The semiconductor die 702 may be a packaged semiconductor die as shown in Figure 6. The semiconductor die 702 may be a power management die, allowing for optimized power consumption such that the RF device 700 can operate within a stable and reliable power limit. Alternatively, the semiconductor die 702 may be a microcontroller allowing the RF device 700 to perform calculation or controlling operations e.g., but not limited to data processing, signal processing or signal control etc. The semiconductor die 702 can be flexibly integrated in the RF device 700 i.e., either within or outside of the substrate 102.

Figure 8 shows a further example of an RF device 800 having a heat sink 802 formed within the substrate 102. The RF device 800 may include some or all features of the RF device 700 of Figure 7 and will be described in regards of differences only. The metal structure 108 comprises the heat sink 802, which may be considered as a block of metal. The heat sink 802 is arranged between the backside 116 of the RF semiconductor die 110 and the second surface 120 of the substrate 102. The heat sink 802 is thermally coupled with the RF semiconductor die 110 such that the heat generated by the RF semiconductor die 110 is efficiently transferred outside of the RF device 100. Thus, the thermal transportation is improved and performance and reliability of the RF device 800 can be enhanced. The heat sink 802 may be exposed from substrate 102, e.g. from the second surface 120. The heat sink 802 may be thermally coupled to a further heat sink for heat dissipation, further increasing the heat transfer from the RF semiconductor die 110.

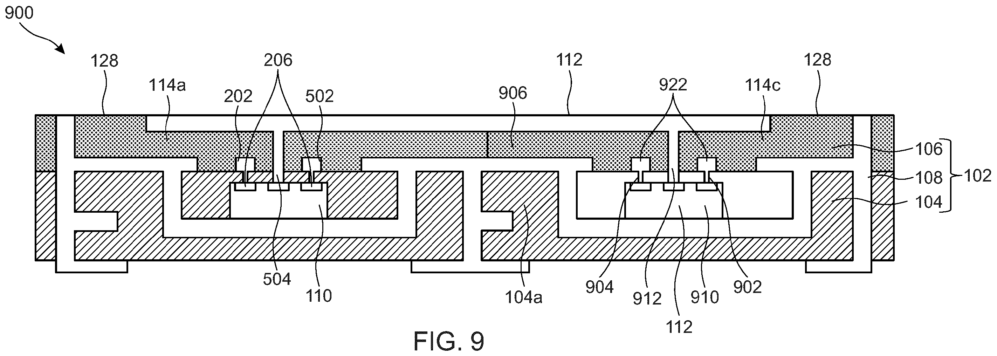

Figure 9 shows a further example of an RF device 900 having more than one RF semiconductor dies coupled with each other. The semiconductor RF dies may for example form a cascaded system. The RF device 900 may include some or all features of the RF device 800 of Figure 8 and will be described in regards of differences only. The RF device 900 may have a further RF semiconductor die 910. The RF semiconductor die 110 may be a primary RF semiconductor die 110 and the further RF semiconductor die 110 may be a secondary RF semiconductor die 910. As described above, the primary RF semiconductor die 110 includes launchers 202, 502 wherein each of the launchers 202, 502 is coupled with a respective RF channel of the primary semiconductor die 110. The secondary RF semiconductor die 910 is also surrounded by the material 104a of the first layer 104 and coupled with the metal structure 108 and the waveguide antenna 114. Similar to the primary RF die 110, the secondary RF semiconductor die 910 includes a first launcher 902 and a second launcher, 904 wherein each of the launcher 902, 904 is coupled with respective RF channel of the secondary RF semiconductor die 910. Each launcher 202, 502, 902, 904 of the primary RF semiconductor die 110 and the secondary RF semiconductor die 910 is coupled with a dedicated portion of the waveguide antenna 114. As shown further in Figure 9, the first launcher 202 of the primary RF semiconductor die 110 is coupled with the first portion 114a, whereas the first launcher 902 of the secondary RF semiconductor die 910 is coupled with another portion 114c of the waveguide antenna 114. The portions 114a and 114c of the waveguide antenna 114 are separated by the separation vias 504 and 912.

Further, the second launcher 502 of the primary RF semiconductor die 110 is coupled with the second launcher 904 of the secondary RF semiconductor die 910 by a transfer waveguide 906 of the waveguide antenna 114. The transfer waveguide 906 is configured to transfer a local oscillator (LO) signal from the primary RF semiconductor die 110 to the secondary RF semiconductor die 910 via the launchers 502, 910, thereby enabling a synchronization of the primary RF semiconductor die 110 with the secondary RF semiconductor die 910. This allows the primary and secondary RF semiconductor die 110, 910 to be operated by a common LO signal generated by a local oscillator of the primary RF semiconductor die 110. This enables the synchronization of operation of the primary and the secondary RF semiconductor die 110, 910 which is achieved by the transfer waveguide 906 of the waveguide antenna 114.

While Figure 9 shows the transfer waveguide 906 for transferring the LO signal, other examples may couple the launchers 502, 902 of the respective RF semiconductor die 110, 910 by one or more metal lines (e.g. strip lines), wherein the metal line is formed by the metal structure 108.

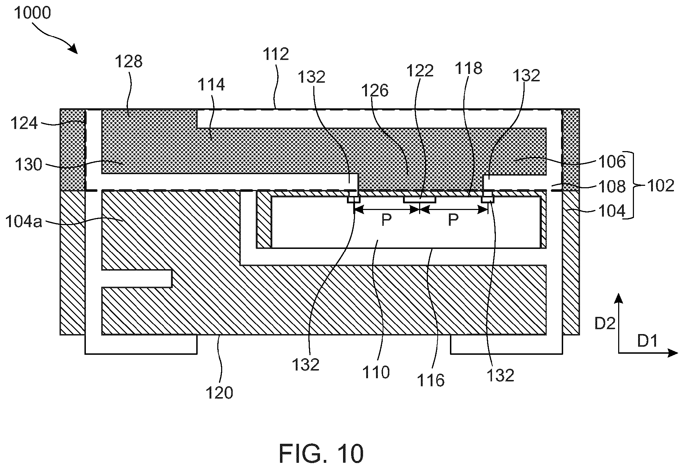

Figure 10 shows as a further example an RF device 1000 including the semiconductor die 110. The RF semiconductor die 110 comprises a plurality of electrical contact pads 132 coupled with the respective electrical contact structure 138. Each electrical contact pad 132 has a pitch dimension P of less than 250 µm. The pitch dimension P is a center to center distance between the electrical contact pad 132 and the chip-integrated launcher or the chip-integrated antenna 122. Each electrical contact pad 132 is coupled with the metal structure 108 of the substrate 102 to provide direct and efficient path for electrical signals to the RF semiconductor die 110. The pitch dimension P may be between 50 µm and 250 µm, in particular 100 µm to 200 µm, in particular 70 µm to 120 µm and provides a high density of the electrical connections. It is to be noted that the electrical contact structure 138 which are part of the metal structure 108 is configured for connecting individually to each electrical contact pad 132. Accordingly, the metal structure 108 comprises connecting structures (e.g. vias) having the same pitch as the electrical contact pads 132. In other words, the metal structure 108 can be used for routing electrical signals and transferring RF signals and thus, RF device 1000 can be made further compact and integrated. To be more specific, by providing the metal structure 108 having connecting structures with small pitch P, the RF semiconductor die 110 is allowed to be a highly integrated IC such as a radar MMIC having a high number of receive and transmit channels.

In some examples. the pitch dimension P is a center to center distance between the electrical contact pad 132 and the launcher 202.

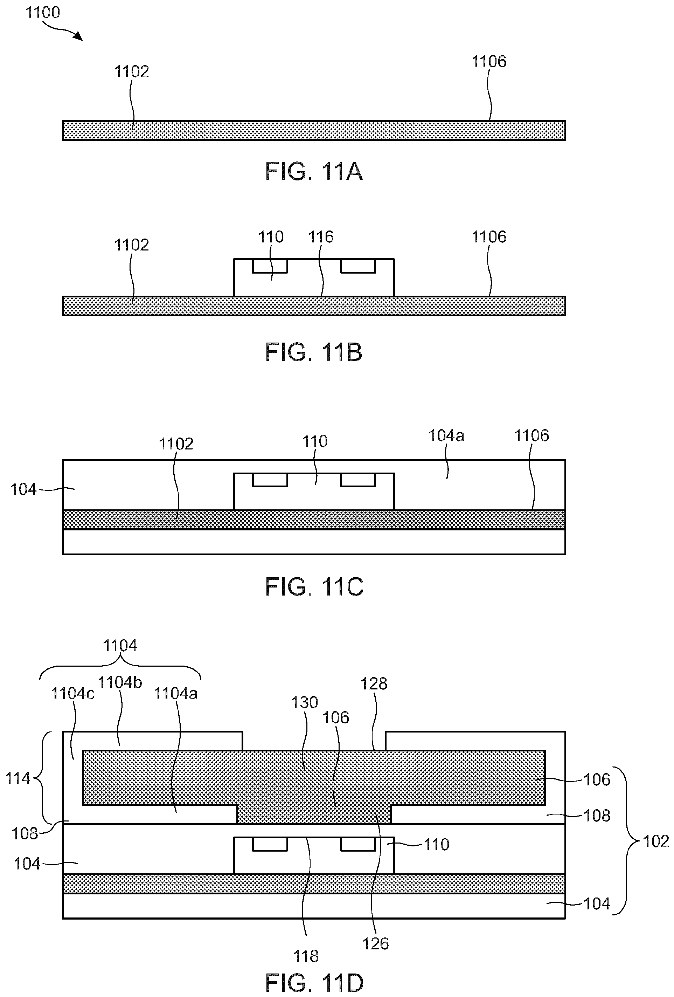

Figures11A to 11D illustrates various steps of a method 1100 of forming the RF devices described in Figures 1 to 10. In some examples, the method makes use of a chip-embedding using PCB manufacturing process steps such as lamination. In one example, the chip-embedding may use a chip-first approach as will be described below. On other examples, a chip last approach may be used. Same reference signs will be used for same or similar features between the method 1100 and the RF devices of Figures 1 to 10. A substrate layer 1102 is provided as shown in Figure 11A. The substrate layer 1102 may be a metal layer or a dielectric layer or a stack of layers including metal layers and dielectric layers. The backside 116 of the RF semiconductor die 110 is arranged over a surface 1106 of the substrate layer 1102 as shown in Figure 11B. In this example, the chip is placed face-up however in other examples a chip-down approach may be used. An adhesive material may be arranged between the backside 116 of the RF semiconductor die 110 and the surface 1106 of the substrate layer 1102. The adhesive material may be e.g. but not limited to an epoxy based adhesive or silicone based adhesives etc. and may have a thickness in a range of 1 µm to 10 µm measured vertically between the backside 116 of the RF semiconductor die 110 and the surface 1106 of the substrate layer 1102. A thickness of the RF semiconductor die 110 may in a range of 50 µm to 100 µm measured between the frontside 118 and the opposing backside of the RF semiconductor die 110. The material 104a is provided over the surface 1106 of the substrate layer 1102 to form the first layer 104 of the substrate 102 such that the RF semiconductor die 110 is embedded and surrounded by the material 104a as shown in Figure 11C. The material 104a may be provided for example using a lamination process in which a layer or a layer stack including the material 104a of the first layer 104 is placed over the RF semiconductor die 110 and heat and pressure is applied for embedding the RF semiconductor die 110 within the first layer 104. In other examples deposition, molding or other techniques may be used. In some examples, the material 104a may include at least one of a polymer material, a prepreg material, an Ajinomoto Build-up Film (ABF) material.

Alternatively, the substrate layer 1102 may be provided with a material like prepreg material and the prepreg material is partially removed by laser etching or chemical etching to expose the substrate layer 1102 from the prepreg material. Then, the RF semiconductor die 110 is attached to the exposed substrate layer 1102, followed by providing the material 104a to form the first layer 104.

Furthermore, the second layer 106 is formed over the first layer 104 as shown in Figure 11D. Forming the second layer 106 includes forming the metal structure 108 and providing the dielectric material 130 of the second metal layer 106. A first section 1104 of the metal structure 108 within the second layer 106 forms the waveguide antenna 114. The first section 1104 of the metal structure 108 may be formed partially before and partially after providing the dielectric material 130 of the second metal layer 106. Thus, the waveguide antenna 114 formed is filled with the dielectric material 130.

The metal structure 108 may be formed by laminating one or more metal layers. Other techniques may use a plating molding or deposition of one more metal layers. The entire surface of the first metal layer 104 facing the frontside 118 of the RF semiconductor die 110 may be provided with a first part 1104a of the first section 1104 of the metal structure 108 e.g., a metal layer and then the first part 1104a of the first section 1104 of the metal structure 108 may be selectively etched. The dielectric mater 130 of the second layer 106 may be provided e.g., by deposition or plating etc. over the first layer 104. The dielectric material 130 surrounds the first part 1104a of the first section 1104 of the metal structure 108. The entire outermost surface of the second layer 106 facing the frontside 118 of the RF semiconductor die 110 may be provided with a second part 1104b of the first section 1104 of the metal structure 108 e.g., a further metal layer and then the second part 1104b of the first section 1104 of the metal structure 108 is selectively etched. The first section 1104 of the metal structure further comprises a vertical via 1104c joining the parts 1104a and 1104b of the first section 1104 of the metal structure 108 which may be formed before providing the dielectric material 130.

The selectively etching of the of the first part 1104a of the first section 1104 of the metal structure 108 comprises forming the inner opening 126. Similarly, the selectively etching of the of the second part 1104b of the first section 1104 of the metal structure 108 comprises forming the outer opening 128.

According to one example, an air-filled waveguide antenna may be formed by selectively removing the dielectric material 130 of the second layer 106. In one example, the dielectric material 130 is selectively removed before forming the second part 1104b of the first section 1104 of the metal structure 108. For example, the dielectric material 130 between two vertical vias 1104c may be removed to form the air-filled waveguide antenna. In one example, the outer opening 128 of the air-filed waveguide antenna may be covered by a further material forming the third layer 402 as shown in Figure 4. In one example, the third layer within the outer opening 128 may be selectively etched to expose the outer opening 128.

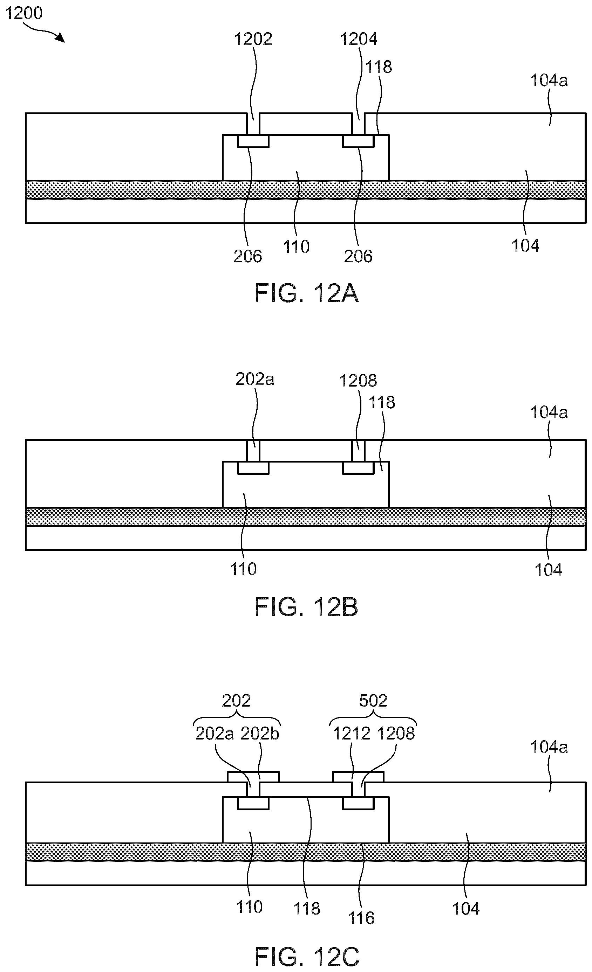

Figures 12A-12C illustrate a further step 1200 of the method 1100. The further step 1200 involves forming the launcher 202, 502. A hole 1202, 1204 is formed to expose the RF contact pad 206 from the material 104a of the first layer 104 as shown in Figure 12A. The RF contact pad 206 may have a pitch of less than 120 µm e.g., 100 µm measured between centers of two neighboring RF contact pads 206 in a direction parallel to the frontside 118 of the RF semiconductor die 110. A depth of the hole 1202, 1204 is same as the thickness of the material 104a of the first layer 104 above the frontside 118 of the semiconductor die 110. The hole 1202, 1204 may be formed by laser drilling, mechanical drilling or by selectively etching the material 104a of the first layer 104. A launcher 202, 502 from the metal structure 108 is formed on the frontside 118 of the RF semiconductor die 110 in which a via 202a, 1208 is formed in the respective hole 1202, 1204 e.g., by plating as shown in Figure 12B. One end of the via 202a, 1208 is coupled with the RF contact pad 206. A diameter of the via less than 50 µm e.g., 30 µm measured in the direction parallel to the frontside 118 of the RF semiconductor die 110.

Further, a second portion 202b, 1212 of the metal structure 108 is formed on the respective other end of the via 202a, 1208. The second portion 202b, 1212 with the respective via 202a, 1208 form the launcher 202, 502 as shown in Figure 12C. A width of the launcher 202, 502 may be less than 100 µm e.g., 70 µm. The width of the launcher 202, 502 is a width of the second portion 202a, 1208 of the metal structure 108 measured in the direction parallel to the frontside 118 of the RF semiconductor die 110. For 100 µm pitch between the RF contact pads 206, and 30 µm width of the launcher 202, 502, a distance between the launchers 202 and 502 may be 30 µm. Thus, for a given width of the RF semiconductor die, a density of launchers can be increased. The density of the launcher implies number of launchers per unit area of the RF semiconductor die.

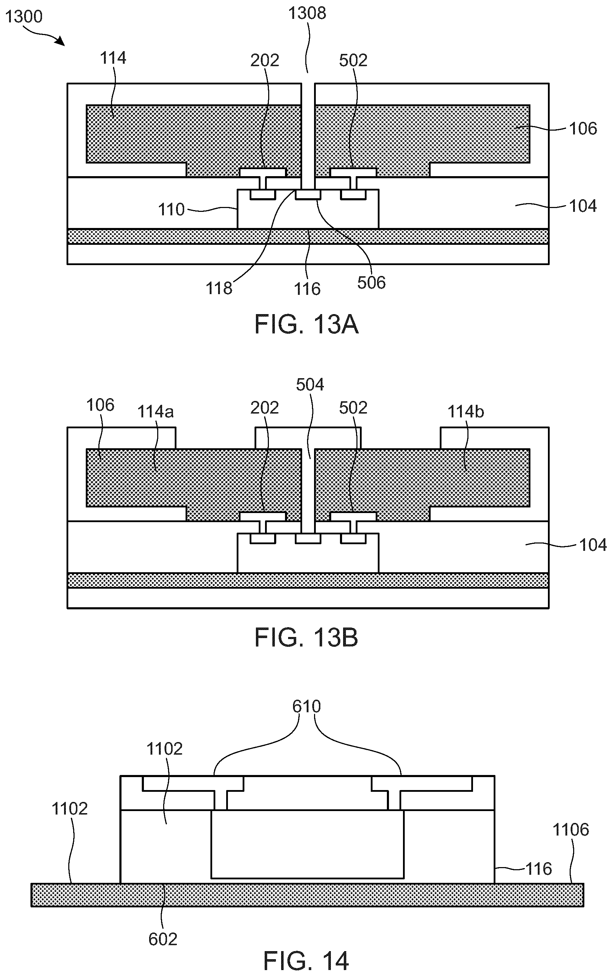

Figures 13A-13B illustrate a further step 1300 of the method 1100 comprising forming the separation via 504 in the waveguide antenna 114. The holes 1202 and 1204 of the Figure 12A are a first hole 1202 and a second hole 1204 respectively. Further, the vias 202a and 1208 of Figure 12B are a first via 202a and a second via 1208 respectively. The portion 1212 of the metal structure is a third portion 1212 of the metal structure 108. The launchers 202 and 502 are the first launcher 202 and the second launcher 502 respectively. After forming the launchers 202, 502, the second layer 106 of the substrate 104, a first hole 1308 may be formed in the second layer 106 of the substrate 102 in a direction vertical to the frontside 118 of the RF semiconductor die 110 as shown in Figure 13A. One end of the first hole 1308 may be between the first launcher 202 and the second launcher 502. The separation via 502 may be formed in the first hole 1308 of the second layer 106 of the substrate 102 e.g., by plating as shown in Figure 13B. The first hole 1308 may extend into the first layer 104 and expose the ground contact pad 506 of the RF semiconductor die 110. The separation via 502 may be mechanically coupled with the ground contact pad 506 of the RF semiconductor die 110.

In some examples, a contact structure from the metal structure 108 may be formed on the ground contact pad 506 before forming the second layer 106. The contact structure may be exposed from the first layer 104. The first hole 1308 in the second layer 106 exposes the contact structure and the separation via 504 is coupled with the contact structure.

The separation via 502 separates the two portions 114a and 114b of the waveguide antenna 114 from each other. The first portion 114a and the second portion 114b of the waveguide antenna 114 are coupled with the first launcher 202 and the second launcher 502 respectively. The first launcher 202 and the second launcher 502 are coupled with the first channel and the second transmission of the RF semiconductor die 110 respectively.

Figure 14 shows an alternative step 1401 of attaching the RF semiconductor die 110 of Figure 11B. Instead of attaching a bare RF semiconductor die 110, the molded RF semiconductor die 610 may be attached to the surface 1106 of the substrate layer 1102. The molded RF semiconductor die 610 has the molded body 602 surrounding the RF semiconductor die 110. Thereafter, the same process steps as described above for the example of a bare RF semiconductor die 110 can be applied.

As described above, the present application discloses a new concept of the RF semiconductor device having a substrate with multiple layers and the metal structure. As described herein, the substrate is used for routing RF signals and electrical signals by embedding the RF semiconductor die within the substrate and forming the waveguide antenna from the substrate. The RF device provides flexible way of having launcher e.g., the launcher can be made from the metal structure of the substrate or the RF semiconductor may comprise the launcher. The substrate may have the protection layer for protecting the RF semiconductor die from humidity and dust. Further, interference of RF signals within the waveguide antenna can be reduced by the separation via. Furthermore, the metal structure may have the heat sink for heat dissipation. The waveguide antenna can be used to transfer signals between different RF semiconductor dies in order to synchronize the RF semiconductor dies.

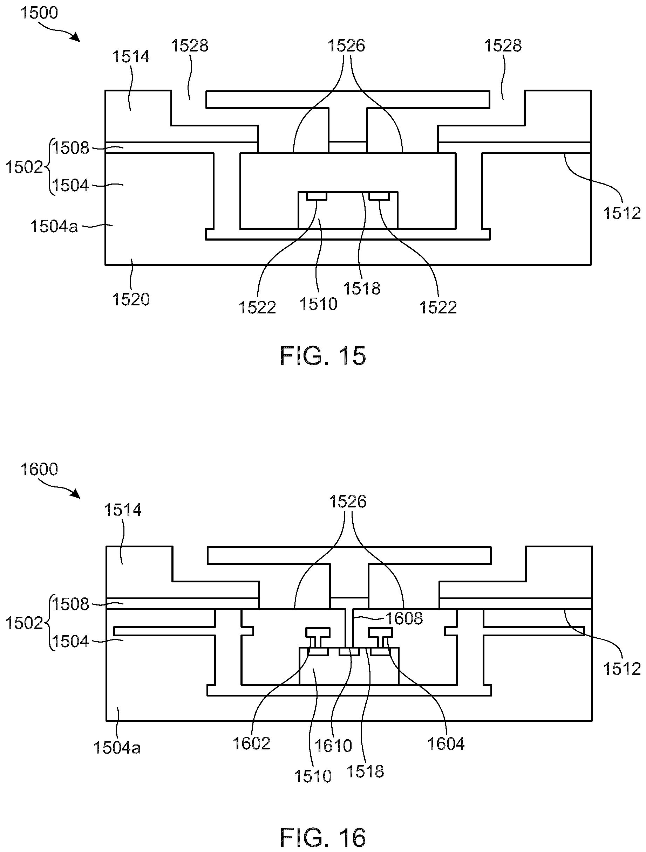

Figure 15 shows a further example of an RF device 1500. The RF device 1500 has a substrate 1502, a bare RF semiconductor die 1510 and a waveguide antenna 1514. The bare RF semiconductor die 1510 is embedded within the substrate 1502 whereas the waveguide antenna 1514 is mounted on the substrate 1502. The bare RF semiconductor die 1510 may be similar to the RF semiconductor die 110 of Figure 1 i.e., the bare RF semiconductor die 1510 may also have the integrated launcher or the integrated antenna 1522 to transmit or receive RF signals in a wireless manner. The substrate 1502 may be a printed circuit board. The substrate 1502 has a first layer 1504 and a metal structure 1508. The bare RF semiconductor die 1510 is arranged within the substrate 1510 such that the frontside 1518 of the bare RF semiconductor die 1510 faces a first surface 1512 of the substrate 1502. Furthermore, the bare RF semiconductor die 1510 is surrounded by a material 1504a of the first layer 1504 of the substrate 1502. The first layer 1504 is similar to the first layer 104 of the substrate 102 of Figure 1. A thickness of the material 1504a of the first layer 1504 between the frontside 1518 and the first surface 1512 of the substrate 1502 may be less than 50 µm and therefore, RF signals can be transmitted and received by the bare RF semiconductor die 1510 without any significant losses.

The metal structure 1508 extends in a direction parallel and in a further direction vertical to the first surface 1512 of the substrate 1502. An inner portion of the metal structure 1508 extends within the first layer 1504 whereas an outer portion of the metal structure 1508 extends outside of the first layer 1504 of the substrate. The outer portion of the metal structure 1508 may extend on the first surface 1512 and an opposing second surface 1520 of the substrate 102. The bare RF semiconductor die 1510 is coupled with the metal structure 1508 similar to the RF semiconductor die 110 of RF device 100 of Figure 1.

Further, the RF device 1500 has the waveguide antenna 1514 mounted over the first surface 1512 of the substrate 1502 to transfer RF signals from the bare RF semiconductor die 1510 to outside of the RF device 1510 or from outside of the RF device 1500 to the bare RF semiconductor die 1510. The waveguide antenna 1514 may screwed or glued directly over the first surface 1512 of the substrate 1502. As shown in Figure 15, the waveguide antenna 1514 is mounted on the outer portion of the metal structure 1508 extending on the first surface 1512 of the substrate 1502. A portion of the waveguide antenna 1514 may be hollow such that the RF signals can pass through the waveguide antenna 1514. The hollow portion of the waveguide antenna 1514 has an inner opening 1526 and an outer opening 1528. The inner opening 1526 faces the integrated antenna or the integrated launcher 1522 of the bare RF semiconductor die 1510 and couples the RF signals between the waveguide antenna 1514 and the bare RF semiconductor die 1510. On the other hand, the outer opening 1528 of the couples the RF signals between the waveguide antenna 1514 and outside of the RF device 1500. The waveguide antenna 1514 may be made of a metal e.g., but not limited to copper, aluminum or an alloy thereof. Alternatively, the waveguide antenna 1514 may be made of plastic however, walls of the hollow portion of the waveguide antenna 1514 are coated with a metal e.g., copper, aluminum or an alloy thereof.

By embedding the bare RF semiconductor die 1510 within the substrate 1502, an overall footprint of the RF device 1500 can be reduced as compared to the traditional RF devices where the RF semiconductor die is molded and then mounted on the substrate. Therefore. for a given dimension of the substrate 1502, the RF device 1500 can have a larger number of channels as compared to the traditional RF devices. By mounting the waveguide antenna 1514 directly on the substrate 1502 and the signal path between the bare RF semiconductor die 1510 and the waveguide antenna 1514 can be shortened thereby reducing transmission losses. As the RF signals are transferred directly between the bare RF semiconductor die 1510 and the waveguide antenna 1514 without any microstrip and solder balls arrays, the launching of RF signals into the waveguide antenna 1514 can be more homogenous and reliable. Overall, the production costs can also be reduced as the packaging of the bare RF semiconductor die and connecting to a substrate (such as a printed circuit board) are integrated into one manufacturing process.

In one example, the metal structure 1508 may further comprise a portion forming a heat sink between the bare RF semiconductor die 1510 and the second surface 1520 of the substrate 1502 opposite to the first surface 1512 similar to heat sink 802 as shown in reference to the RF device 800 of Figure 8. An additional heat sink may be coupled to the heat sink for further enhancing the heat transfer from the bare RF semiconductor die 1510.

In a further example, the RF device 1500 may further comprise a semiconductor die embedded within the substrate 1502 or arranged on the substrate 1502 in a similar manner as shown in reference to the RF device 700 of Figure 7.

Figure 16 shows a further example of an RF device 1600. The RF device 1600 may include some or all features of the RF device 1500 of Figure 15 and will be described in regards of differences only. The RF signals can be coupled between the bare RF semiconductor die 1510 and the waveguide antenna 1514 via a launcher 1602, 1604 instead of the chip-integrated antenna or the chip-integrated launcher integrated in the RF semiconductor die 1510. The launcher 1602, 1604 is formed by a first section of the metal structure 1508. The launcher 1602, 1604 is similar to the launcher 202, 502 of the RF device 500 of Figure 5.

In a further example, the launcher 1602, 1604 may be exposed from the material 1504a of the first layer 1504 of the substrate 1502 to reduce the losses occurring due to the material of the first layer 1504 of the substrate 1502.

The launcher 1602 may be a first launcher 1602 coupled with a first channel of the bare RF semiconductor die and the launcher 1604 may be a second launcher within the substrate 1502 coupled with a second channel of the bare RF semiconductor die 1510. The first channel and the second channel may be a transmission channel or a receive channel. The first launcher 1602 is coupled with a first portion 1514a of the waveguide antenna 1514 and the second launcher 1604 is coupled with a second portion 1514b of the waveguide antenna 1514.

Separately or in combination, the metal structure 1508 further comprises a separation via 1608 extending in the second direction vertical to the first surface 1512 of the substrate 1502. Furthermore, the separation via 1608 may be between the launchers 1602 and 1604 and mechanically coupled with a ground contact pad 1610 of the RF semiconductor die 1510. The separation via 1608 separates the first portion 1514a of the waveguide antenna 1514 from the second portion 1514b of the waveguide antenna 1514. The separation via 1608 reflects the RF signals and thereby avoids interference of the RF signals in the first portion 1514a from the second portion 1514b of the waveguide antenna 1514. Therefore, the interference between the RF signals transmitted by the respective launcher 1602, 1604 within the waveguide antenna 114 can be significantly reduced and the RF channels can be separated.

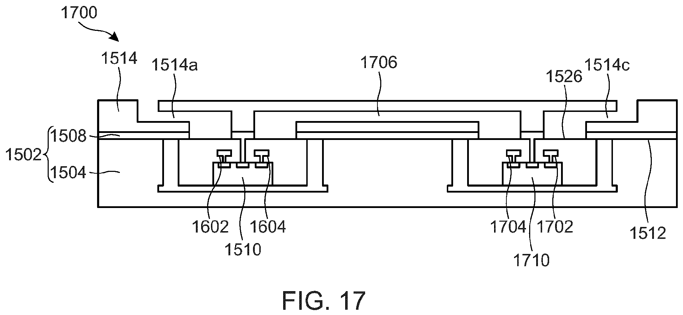

Figure 17 shows a further example of an RF device 1700 having more than one bare RF semiconductor dies coupled with each other. The bare semiconductor RF dies may for example form a cascaded system. The RF device 1700 may include some or all features of the RF device 1600 of Figure 16 and will be described in regards of differences only. The RF device 1700 may have a further bare RF semiconductor die 1710. The bare RF semiconductor die 1510 may be a primary bare RF semiconductor die 1510 and the further bare RF semiconductor die 1710 may be a secondary bare RF semiconductor die 1710. As described above, the primary bare RF semiconductor die 1510 comprises launchers 1602, 1604 wherein each of the launchers 1602, 1604 is coupled with a respective RF channel of the primary bare RF semiconductor die 1510. The secondary bare RF semiconductor die 1710 is also surrounded by the material of the first layer 1504 and coupled with the metal structure 1508 and the waveguide antenna 1514 similar to the primary bare RF semiconductor die 1510.

Further, the secondary bare RF semiconductor die 1710 comprises a first launcher 1702 and a second launcher 1704 wherein each of the launcher 1702, 1704 is coupled with a respective RF channel of the secondary bare RF semiconductor die 1710. The first launcher 1502, 1702 of each bare RF semiconductor die 1510, 1710 is coupled with the first portion 1514a and another portion 1514c of the waveguide antenna 1514. The portions 1514a and 1514c are separated by the separation vias 1608 and 1710 as shown in Figure 18. The second launcher 1604 of the primary bare RF semiconductor die 1510 is coupled with the second launcher 1704 of the secondary bare RF semiconductor die 1710 by a transfer waveguide 1706 integrated in the waveguide antenna 1514. The transfer waveguide 1706 is configured to transfer a local oscillator (LO) signal from the primary bare RF semiconductor die 1510 to the secondary bare RF semiconductor die 1710 via the launchers 1604, 1710, thereby enabling a synchronization of the primary bare RF semiconductor die 1510 with the secondary bare RF semiconductor die 1710. This allows the primary and secondary bare RF semiconductor die 1510, 1710 to be operated by a common LO signal generated by a local oscillator of the primary Bare RF semiconductor die 1510. This enables the synchronization of operation of the primary and the secondary Bare RF semiconductor die 1510, 1710 which is achieved by the transfer waveguide 1706 of the waveguide antenna 1514.

In one example, the transfer waveguide is embedded within a second layer of the substrate 1502. The second layer may be directly below the first surface of the substrate 1502. The waveguide antenna 1514 may be partially integrated within the substrate 1502. Thus, a footprint of the waveguide antenna 1514 on the substrate 1502 may be reduced. The second layer and the transfer waveguide may be similar to the second layer 106 and the transfer waveguide 906 of the RF device 900 of Figure 9.

Further examples:
Example 1: A radio-frequency (RF) device comprising: a substrate comprising a first layer, a second layer and a metal structure, an RF semiconductor die embedded within the substrate and surrounded by a material a of the first layer of the substrate and wherein the RF semiconductor die is coupled with the metal structure, wherein the metal structure extends in a first direction (D1) parallel and in a second direction (D2) vertical to a first surface of the substrate, and a waveguide antenna formed from the metal structure in the second layer of the substrate to transfer RF signals from the RF semiconductor die to outside of the RF device or from outside of the RF device to the RF semiconductor die.
Example 2: The RF device according to example 1, further comprising a launcher within the substrate, wherein the launcher is coupled with the RF semiconductor die, and wherein the launcher is configured to couple RF signals between the RF semiconductor die and the waveguide antenna.
Example 3: The RF device according to example 2, wherein the RF semiconductor die comprises the launcher.
Example 4: The RF device according to examples 1 to 3, wherein the substrate comprises a third layer covering an opening of the waveguide antenna, wherein the opening of the waveguide antenna extends to the first surface of the substrate.
Example 5: The RF device according to examples 1 to 4, wherein the waveguide antenna is an air-filled waveguide antenna or dielectric-filled waveguide antenna.
Example 6: The RF device according to examples 1 to 5, wherein the launcher is a first launcher coupled with a first channel of the RF semiconductor die and the RF device further comprising: a second launcher within the substrate coupled with a second channel of the RF semiconductor die, wherein the metal structure further comprises a via in the second direction D2, and wherein the via separates a first portion of the waveguide antenna from a second portion of the waveguide antenna, where the first portion and the second portion of the waveguide antenna are coupled with the first launcher and the second launcher respectively.
Example 7: The RF device according to examples 1 to 6, wherein the RF semiconductor die has a molded body surrounding the RF semiconductor die and wherein the RF semiconductor die is at least partially exposed from the molded body.
Example 8: The RF device according to example 7, wherein the molded body comprises a launcher.
Example 9: The RF device according to examples 1 to 8, wherein the RF semiconductor die comprises a plurality of contact pads, wherein each contact pad has a pitch dimension (P) of less than 250 µm and wherein each contact pad is coupled with the metal structure of the substrate to provide electrical signals to contact pads.
Example 10: The RF device according of examples 1 to 9, further comprising a further semiconductor die embedded within or arranged on the substrate.
Example 11: The RF device according to examples 1 to 10, wherein the metal structure further comprises a heat sink between the RF semiconductor die and a second surface of the substrate opposite to the first surface.
Example 12: The RF device according to examples 1 to 11, wherein the RF semiconductor die is a first RF semiconductor die and the RF device further comprising: a second RF semiconductor die embedded within the substrate and surrounded by the material of the first layer of the substrate, wherein the second RF semiconductor die is coupled with the metal structure and the waveguide antenna, wherein the waveguide antenna comprises a transfer waveguide configured to transfer the RF signals between the first RF semiconductor die and the second RF semiconductor die.
Example 13: The RF device according to examples 1 to 12, wherein the substrate is a printed circuit board.
Example 14: A method of forming a radio-frequency (RF) device comprising: an RF semiconductor die embedded within a substrate comprising: providing a substrate layer, attaching a first side of the RF semiconductor die to a surface of the substrate layer, providing a material over the surface of the substrate layer to form a first layer of the substrate such that the RF semiconductor die is surrounded by the material, forming a second layer of the substrate over the first layer of the substrate, wherein forming the second layer comprises forming a metal structure, and wherein a first section of the metal structure forms a waveguide antenna.
Example 15: The method of example 14, further comprising: forming a first hole to expose a second side of the RF semiconductor die from the material of the first layer of the substrate before forming the second layer of the substrate, wherein the second side of the RF semiconductor die is opposite to the first side of the RF semiconductor die, wherein forming the metal structure comprises forming a first via in the first hole of the first layer of the substrate, and forming a second section of the metal structure coupled with the first via to form a first launcher for coupling RF signals between the RF semiconductor die and the waveguide antenna.
Example 16: The method of example 15, further comprising: forming a second hole to expose the second side of the RF semiconductor die from the material of the first layer of the substrate before forming the second layer of the substrate, wherein forming the metal structure comprises forming a second via in the second hole of the first layer of the substrate, and forming a third section of the metal structure coupled with the second via to form a second launcher, forming a first hole in the second layer of the substrate in a first direction vertical to the first side of the RF semiconductor die, forming a third via in the first hole of the second layer of the substrate, wherein the third via separates a first portion of the waveguide antenna from a second portion of the waveguide antenna, wherein the first portion and the second portion of the waveguide antenna are coupled with the first launcher and the second launcher respectively and wherein the first launcher and the second launcher are coupled with a first channel and a second transmission of the RF semiconductor die respectively.
Example 17: The method of examples 14 to 16, wherein forming the metal structure further comprises etching a second part of the first section of the metal structure to form an opening in the waveguide antenna and wherein the second part of the first section of the metal structure extends over an outermost surface of the second layer.
Example 18: The method of example 17, further comprising arranging a third material over the opening of the waveguide antenna.
Example 19: The method of example 18, further comprising etching the first material to expose the opening of the waveguide antenna.
Example 20: The method of examples 14 to 19, wherein attaching the RF semiconductor die to the surface of the substrate layer comprises attaching the RF semiconductor die having a molded body surrounding the RF semiconductor die.
Example 21: A radio-frequency (RF) device comprising: a substrate comprising a first layer and a metal structure, a bare RF semiconductor die embedded within the substrate, wherein the bare RF semiconductor die is surrounded by and in contact with a material of the first layer of the substrate, wherein the metal structure extends in a first direction parallel and in second direction vertical to a first surface of the substrate, a waveguide antenna mounted over the first surface of the substrate to transfer RF signals from the bare RF semiconductor die to outside of the RF device via the metal structure or from outside of the RF device to the bare RF semiconductor die via the metal structure.
Example 22: The RF device according to example 21, wherein the metal structure comprises a first portion forming a launcher for coupling RF signals between the bare RF semiconductor die and the waveguide antenna.
Example 23: The RF device according to any one of examples 21 or 22, wherein the launcher is exposed from the material of the first layer of the substrate.
Example 24: The RF device according to example 21, wherein the bare RF semiconductor die comprises a launcher for coupling RF signals between the bare RF semiconductor die and the waveguide antenna.
Example 25: The RF device according to any one of examples 22 to 24, wherein the launcher is a first launcher coupled with a first channel of the bare RF semiconductor die and the RF device further comprising: a second launcher within the substrate coupled with a second channel of the bare RF semiconductor die, wherein the metal structure further comprises a via in the second direction vertical to first surface of the substrate, and wherein the via separates a first portion of the waveguide antenna from a second portion of the waveguide antenna, where the first portion and the second portion of the waveguide antenna are coupled with the first launcher and the second launcher of the bare RF semiconductor die respectively.
Example 26: The RF device according to any one of examples 21 to 25, wherein the metal structure further comprises a second portion forming a heat sink between the bare RF semiconductor die and a second surface of the substrate opposite to the first surface.
Example 27: The RF device according to any one of examples 21 to 26, further comprising a further semiconductor die embedded within the substrate or arranged on the substrate.
Example 28: The RF device according to any one of examples 21 to 27, wherein the bare RF semiconductor die is a first bare RF semiconductor die, and the RF device further comprising: a second bare RF semiconductor die embedded within the substrate, wherein the second bare RF semiconductor die is surrounded by and in contact with the material of the first layer of the substrate, wherein the waveguide antenna comprises a transfer waveguide configured to transfer RF signals between the first bare RF semiconductor die and the second bare RF semiconductor die.
Example 29: The RF device according to example 28, wherein the transfer waveguide is embedded within a second layer of the substrate.
Example 30: The RF device according to any one of examples 21 to 29, wherein the substrate is a printed circuit board.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

It should be noted that the methods and devices including its preferred embodiments as outlined in the present document may be used stand-alone or in combination with the other methods and devices disclosed in this document. In addition, the features outlined in the context of a device are also applicable to a corresponding method, and vice versa. Furthermore, all aspects of the methods and devices outlined in the present document may be arbitrarily combined. In particular, the features of the claims may be combined with one another in an arbitrary manner.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiments outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. A radio-frequency (RF) device comprising:
a substrate (102) comprising a first layer (104), a second layer (106) and a metal structure (108),
an RF semiconductor die (110) embedded within the substrate (102) and surrounded by a material (104a) of the first layer (104) of the substrate (102) and wherein the RF semiconductor die (110) is coupled with the metal structure (108),
wherein the metal structure (108) extends in a first direction (D1) parallel and in a second direction (D2) vertical to a first surface (112) of the substrate (102), and
a waveguide antenna (114) formed from the metal structure (108) in the second layer (106) of the substrate (102) to transfer RF signals from the RF semiconductor die (110) to outside of the RF device or from outside of the RF device to the RF semiconductor die (110).

2. The RF device according to claim 1, further comprising a launcher (202) within the substrate (102), wherein the launcher (202) is coupled with the RF semiconductor die (110), and wherein the launcher (202) is configured to couple RF signals between the RF semiconductor die (110) and the waveguide antenna (114).

3. The RF device according to claim 2, wherein the RF semiconductor die (110) comprises the launcher (122).

4. The RF device according to claims 1 to 3, wherein the substrate (102) comprises a third layer (402) covering an opening (128) of the waveguide antenna (114), wherein the opening (128) of the waveguide antenna (114) extends to the first surface (112) of the substrate (102).

5. The RF device according to claims 1 to 4, wherein the waveguide antenna (114) is an air-filled waveguide antenna or dielectric-filled waveguide antenna.

6. The RF device according to claims 1 to 5, wherein the launcher (202) is a first launcher (202) coupled with a first channel of the RF semiconductor die (110) and the RF device further comprising:
a second launcher (502) within the substrate (102) coupled with a second channel of the RF semiconductor die (110),
wherein the metal structure (108) further comprises a via (504) in the second direction (D2), and
wherein the via (504) separates a first portion (114a) of the waveguide antenna (114) from a second portion (114b) of the waveguide antenna (114), wherein the first portion (114a) and the second portion (114b) of the waveguide antenna (114) are coupled with the first launcher (202) and the second launcher (502) respectively.

7. The RF device according to claims 1 to 6, wherein the RF semiconductor die (110) has a molded body (602) surrounding the RF semiconductor die (110) and wherein the RF semiconductor die (110) is at least partially exposed from the molded body (602).

8. The RF device according to claim 7, wherein the molded body (602) comprises a launcher (604).

9. The RF device according to claims 1 to 8, wherein the RF semiconductor die (110) comprises a plurality of contact pads (132), wherein each contact pad (132) has a pitch dimension (P) of less than 250 µm and wherein each contact pad (132) is coupled with the metal structure (108) of the substrate (102) to provide electrical signals to contact pads (132).

10. The RF device according of claims 1 to 9, further comprising a further semiconductor die (702) embedded within or arranged on the substrate (102).

11. The RF device according to claims 1 to 10, wherein the metal structure (108) further comprises a heat sink (802) between the RF semiconductor die (110) and a second surface (120) of the substrate opposite to the first surface (112).

12. The RF device according to claims 1 to 11, wherein the RF semiconductor die (110) is a first RF semiconductor die (110) and the RF device further comprising:
a second RF semiconductor die (910) embedded within the substrate (102) and surrounded by the material (104a) of the first layer (104) of the substrate (102),
wherein the second RF semiconductor die (910) is coupled with the metal structure (108) and the waveguide antenna (114),
wherein the waveguide antenna (114) comprises a transfer waveguide (906) configured to transfer the RF signals between the first RF semiconductor die (110) and the second RF semiconductor die (910).

13. The RF device according to claims 1 to 12, wherein the substrate (102) is a printed circuit board.

14. A method of forming a radio-frequency (RF) device comprising an RF semiconductor die (110) embedded within a substrate (102) comprising:
providing a substrate layer (1102),
attaching a first side (116) of the RF semiconductor die (110) to a surface (1106) of the substrate layer (1102),
providing a material (104a) over the surface (1106) of the substrate layer (1102) to form a first layer (104) of the substrate (102) such that the RF semiconductor die (110) is surrounded by the material (104a),
forming a second layer (106) of the substrate (102) over the first layer (104) of the substrate (102), wherein forming (1107) the second layer (106) comprises forming a metal structure (108), and
wherein a first section (1104) of the metal structure (108) forms a waveguide antenna (114).

15. The method of claim 14, further comprising:
forming a first hole (1202) to expose a second side (118) of the RF semiconductor die (110) from the material (104a) of the first layer (104) of the substrate (102) before forming the second layer (106) of the substrate (102),
wherein the second side (118) of the RF semiconductor die (110) is opposite to the first side (116) of the RF semiconductor die (110),
wherein forming the metal structure (108) comprises forming a first via (202a) in the first hole (1202) of the first layer (104) of the substrate (102) and forming a second section (202b) of the metal structure (108) coupled with the first via (202a) to form a first launcher (202) for coupling RF signals between the RF semiconductor die (110) and the waveguide antenna (114).

16. The method of claim 15, further comprising:
forming a second hole (1204) to expose the second side (118) of the RF semiconductor die (110) from the material (104a) of the first layer (104) of the substrate (102) before forming the second layer (106) of the substrate (102),
wherein forming the metal structure (108) comprises forming a second via (1208) in the second hole (1204) of the first layer (104) of the substrate (102), and forming a third section (1212) of the metal structure (108) coupled with the second via (1208) to form a second launcher (502),
forming a first hole (1308) in the second layer (106) of the substrate (102) in a first direction vertical to the first side (116) of the RF semiconductor die (110),
forming a third via (504) in the first hole (1308) of the second layer (106) of the substrate (102),
wherein the third via (504) separates a first portion (114a) of the waveguide antenna (114) from a second portion (114b) of the waveguide antenna (114),
wherein the first portion (114a) and the second portion (114b) of the waveguide antenna (114) are coupled with the first launcher (202) and the second launcher (502) respectively and
wherein the first launcher (202) and the second launcher (502) are coupled with a first channel and a second transmission of the RF semiconductor die (110) respectively.

17. The method of claims 14 to 16, wherein forming the metal structure (108) further comprises etching a second part (1104b) of the first section (1104) of the metal structure (108) to form an opening (128) in the waveguide antenna (114) and wherein the second part (1104b) of the first section (1104) of the metal structure (108) extends over an outermost surface (1404) of the second layer (106).

18. The method of claim 17, further comprising arranging a further material (402) over the opening (128) of the waveguide antenna (114).

19. The method of claim 18, further comprising etching the further material to expose the opening (128) of the waveguide antenna (114).

20. The method of claims 14 to 19, wherein attaching the RF semiconductor die (110) to the surface (1106) of the substrate layer (1102) comprises attaching the RF semiconductor die (110) having a molded body (602) surrounding the RF semiconductor die (110).
